# EUROPEAN PATENT APPLICATION

(11) **EP 4 675 654 A2**
(43) Date of publication of application: **07.01.2026**
(21) Application number: 25186834.5
(22) Date of filing: 02.07.2025
(51) Int. Cl.: H01F 27/29

(54) **SURFACE-MOUNT-TECHNOLOGY-TO-PIN-THROUGH-HOLE ADAPTER**

(30) Priority: 02.07.2024 US 202463667048 P
(71) Applicant: Murata Manufacturing Co., Ltd., Nagaokakyo-shi, Kyoto 617-8555 (JP)
(72) Inventor: SIDAPARA, Rohit, Kyoto, 617-8555 (JP); FRANCIS, Lee, Kyoto, 617-8555 (JP)
(74) Representative: Lorenz Seidler Gossel Part. mbB

(57) **Abstract**

An electronic module includes a substrate including a primary conductive pattern and a secondary conductive pattern; a magnetic core located on or above the substrate; a primary winding including a first portion that extends around at least a portion of the magnetic core and that is connected to the primary conductive pattern; a secondary winding including a second portion that extends around at least a portion of the magnetic core and that is connected to the secondary conductive pattern; an electronic component located on the substrate; and an adapter that is connected to the electronic module and that includes at least one through-hole pin configured to through-hole mount the electronic module.

## Description

### BACKGROUND OF THE INVENTION

### 1. Field of the Invention

The present invention relates to adapters. More specifically, the present invention relates to surface-mount-technology-to-pin-through-hole adapters for magnetic components or electronic modules.

### 2. Description of the Related Art

It is known that magnetic components or electronic modules can include surface mount technology (SMT) that allows the magnetic component or the electronic module to be attached to a host substrate by soldering. But SMT magnetic components or electronic modules cannot be attached to a host substrate with through holes. It is also known that magnetic components or electronic modules can include through-hole pins that can be inserted into holes in a host substrate and then soldered. But magnetic components or electronic modules with SMT cannot be used with a host substrate with through holes, and magnetic components or electronic modules with through-hole pins cannot be used with a host substate with SMT pads. Providing magnetic components or electronic modules that can be used with SMT and through holes requires separately designing and testing packages that are suitable for SMT and packages that are suitable for through holes, which increases the cost and the amount of time needed to bring a magnetic component or an electronic module to market. Thus, it is desirable to provide an adapter that is less expensive and easier to design and test and that can be used to allow SMT magnetic components or electronic modules to be mounted to a host substrate using through holes.

### SUMMARY OF THE INVENTION

To overcome the problems described above, example embodiments of the present invention provide adapters that each allow surface-mount magnetic components or electronic modules to be through-hole mounted.

According to an example embodiment of the present invention, an electronic module includes a substrate including a primary conductive pattern and a secondary conductive pattern; a magnetic core located on or above the substrate; a primary winding including a first portion that extends around at least a portion of the magnetic core and that is connected to the primary conductive pattern; a secondary winding including a second portion that extends around at least a portion of the magnetic core and that is connected to the secondary conductive pattern; and an electronic component located on the substrate; and an adapter that is connected to the electronic module and that includes at least one through-hole pin configured to through-hole mount the electronic module.

The electronic module can further include a block coil that includes a first terminal that defines the first portion of the primary winding and a second terminal that defines the second portion of the secondary winding. The electronic module can further include a first wire bond that defines the first portion of the primary winding and a second wire bond that defines the second portion of the secondary winding. The block coil can include additional first terminals and additional second terminals; the first terminal and the additional first terminals can define a first terminal group; and the second terminal and the additional second terminals can define a second terminal group. Each terminal in the first terminal group can be connected to a corresponding primary conductive pattern; and each terminal in the second terminal group can be connected to a corresponding secondary conductive pattern. The first terminal group can be located next to and spaced away from the second terminal group.

The substrate can include first and second layers. The primary conductive pattern can be in the first layer; the secondary conductive pattern can be in the second layer; and from a side view of the substrate, a portion of the primary conductive pattern and a portion of the secondary conductive pattern can overlap vertically. The electronic module can further include an additional primary conductive pattern in a third layer of the substrate and an additional secondary conductive pattern in a fourth layer of the substrate, wherein from the side view of the substrate, a portion of the additional primary conductive pattern and a portion of the additional secondary conductive pattern can overlap vertically.

The electronic module can further include an insulating material covering the substrate, the magnetic core, the primary winding, and the secondary winding. The electronic component can include an integrated circuit (IC) and/or a capacitor.

According to an example embodiment of the present invention, a through-hole-mountable element includes an adapter including a through-hole pin and includes a magnetic component including a substrate including a conductive pattern, a magnetic core located on or above the substrate, and a winding that includes a portion that extends around at least a portion of the magnetic core and that is connected to the conductive patter. The magnetic component is located within the adapter such that the magnetic component engages the through-hole pin such that the magnetic component is through-hole mountable.

The adapter can includes an adapter housing, and the through-hole pin can include a through-hole-mounting end that extends to an exterior of the adapter housing and can include a surface mount technology (SMT) end that extends to an interior of the adapter. The SMT end of the through-hole pin can include a spring arm. The spring arm can press on the magnetic component with a retaining force. The SMT end of the through-hole pin can include a solderable end.

The magnetic component can include a component housing that includes a surface mount technology (SMT) pad on an exterior surface of the component housing, and the SMT end of the through-hole pin can engage with the SMT pad on the component housing. The adapter housing can include a lever arm that presses on the magnetic component with a retaining force. The through-hole pin can extend in a first direction, and the lever arm can extend in a second direction parallel or substantially parallel to the first direction. The adapter can includes at least one additional through-hole pin, wherein each of the at least one additional through-hole pin can include a through-hole-mounting end that extends to an exterior of the adapter housing and a SMT end that extends to an interior of the adapter, and the through-hole pin and the at least one additional through-hole pin can be arranged in a single line. The component housing can include at least one additional SMT pad, and the SMT end of each of the at least one additional through-hole pin can engage with a corresponding SMT pad of the at least one additional SMT pad on the component housing.

The magnetic component can be included in an electronic module that includes an electronic component on the substrate. The through-hole-mountable element can further include a block coil that includes a terminal that defines the portion of the winding. The block coil can include an additional terminal. The through-hole-mountable element can further include a wire bond that defines the portion of the winding.

According to an example embodiment of the present invention, a system includes a host substrate including a through hole and includes a through-hole pin of the through-hole-mountable element of one of the various other example embodiments of the present invention extends into the through hole of the host substrate to attach the through-hole-mountable element to the host substrate.

The through hole can include a plated through hole.

The above and other features, elements, characteristics, steps, and advantages of the present invention will become more apparent from the following detailed description of example embodiments of the present invention with reference to the attached drawings.

### BRIEF DESCRIPTION OF THE DRAWINGS

Fig. 1 is a top perspective view of block coils mounted to a substrate of a magnetic component.
Fig. 2 is a top view of the block coils mounted to a PCB of the magnetic component of Fig. 1.
Fig. 3 is a top perspective view of block coils mounted to a PCB of the magnetic component of Fig. 1 in an electronic module.
Fig. 4 is a top perspective view of the electronic module of Fig. 3 with insulating material covering the block coils.
Fig. 5 is a top view of the electronic module of Fig. 3.
Fig. 6 is top perspective view of the block coil of Fig. 1.
Fig. 7 is bottom perspective view of the block coil of Fig. 1.
Fig. 8 is a top perspective view of block coils with terminals with different widths.
Fig. 9 shows top views of different layers of the PCB that can be used with the electronic module of Fig. 3.
Fig. 10 is a partial sectional view of the electronic module of Fig. 4 with insulating material covering the block coils.
Figs. 11-15 are perspective views showing a method of manufacturing the electronic module of Fig. 3.
Fig. 16 is a sectional view of block coil mounted to a single-layer substrate of an electronic component.
Fig. 17 is a top view of the top layer of the substrate of Fig. 16.
Fig. 18 is a sectional view of a magnetic component showing various distances.
Fig. 19 shows an E-E or E-I magnetic core that can be used with three block coils.
Fig. 20 shows a rod-shaped magnetic core that can be used with a single block coil.
Figs. 21-26 show example substrates that can be used in the magnetic component of Fig. 1 and the electronic module of Fig. 3.
Fig. 27 is a top perspective view of a magnetic component with a spacer attached to a core.
Fig. 28 is a top perspective view of the magnetic component of Fig. 27.
Fig. 29 is a top perspective view of a magnetic component with a spacer that is attached to a core and that includes grooves.
Figs. 30 and 31 show a magnetic component with a header with plated traces and wire bonds.
Fig. 32 shows a through-hole-mountable element that includes an adapter with through-hole pins with spring arms.
Fig. 33 is a side view of the through-hole-mountable element of Fig. 32.
Figs. 34 and 35 are back and front perspective views of the through-hole-mountable element of Fig. 32.
Figs. 36 and 37 are front perspective and side views of the adapter of Fig. 32.
Fig. 38 shows a through-hole-mountable element that includes an adapter with through-hole pins with solderable ends.
Figs. 39 and 40 are front and top views of the through-hole-mountable element of Fig. 38.
Figs. 41 and 42 are front perspective and top views of the adapter of Fig. 38.
Fig. 43 shows another through-hole-mountable element that includes an adapter with through-hole pins with solderable ends.
Fig. 44 is a back perspective view of the through-hole-mountable element of Fig. 43.
Figs. 45 and 46 are front and back perspective views of the adapter of Fig. 43.
Fig. 47 shows a magnetic component or electronic module that can be used with a through-hole-mountable element.
Figs. 48 and 49 shows a through-hole-mountable element mounted to a host substrate.

### DETAILED DESCRIPTION OF EXAMPLE EMBODIMENTS

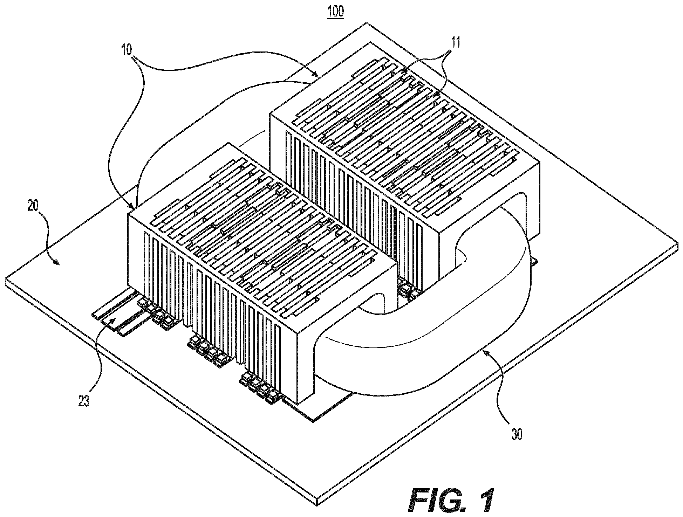

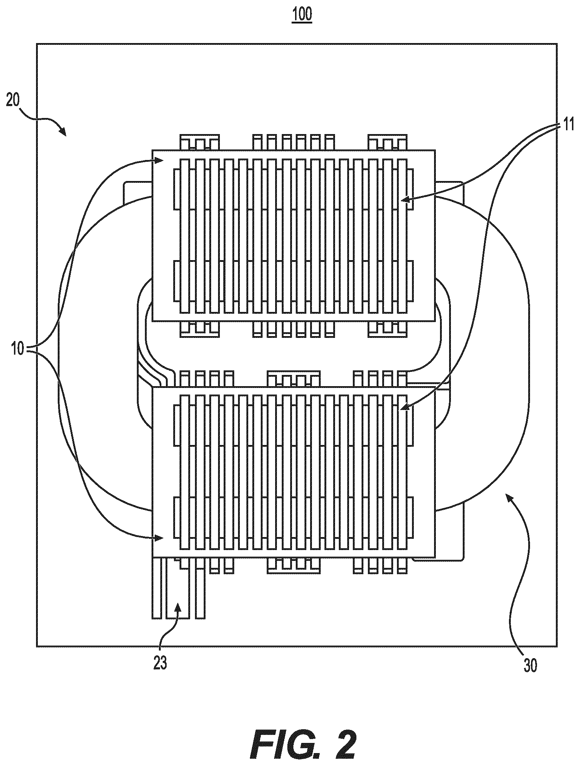

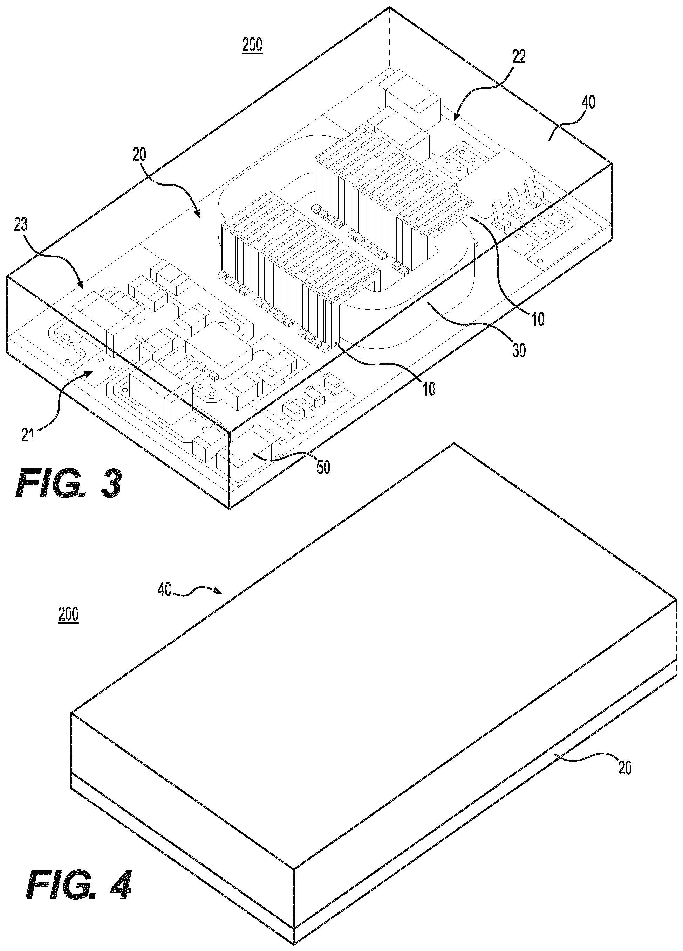

Figs. 1 and 2 shows a magnetic component 100 that includes a substrate 20, a magnetic core 30, and two block coils 10. Figs. 3-5 show an electronic module 200 that includes the magnetic component 100 of Fig. 1 and additional electronic component(s) 50. Although two block coils 10 are shown in Fig. 1-5, any number of block coils 10 can be used, including a single block coil 10.

The magnetic component 100 can include one or more windings that wind around the magnetic core 30. For example, the magnetic component 100 can include a primary winding and a secondary winding that both extend around the magnetic core 30. Each winding can include one or more terminals 11 in a block coil or block coils 10 and can include one or more traces or conductive patterns 23 on or in the substrate 20. The terminals 11 can define portions of the windings, and the traces or conductive patterns 23 can also define portions of the windings.

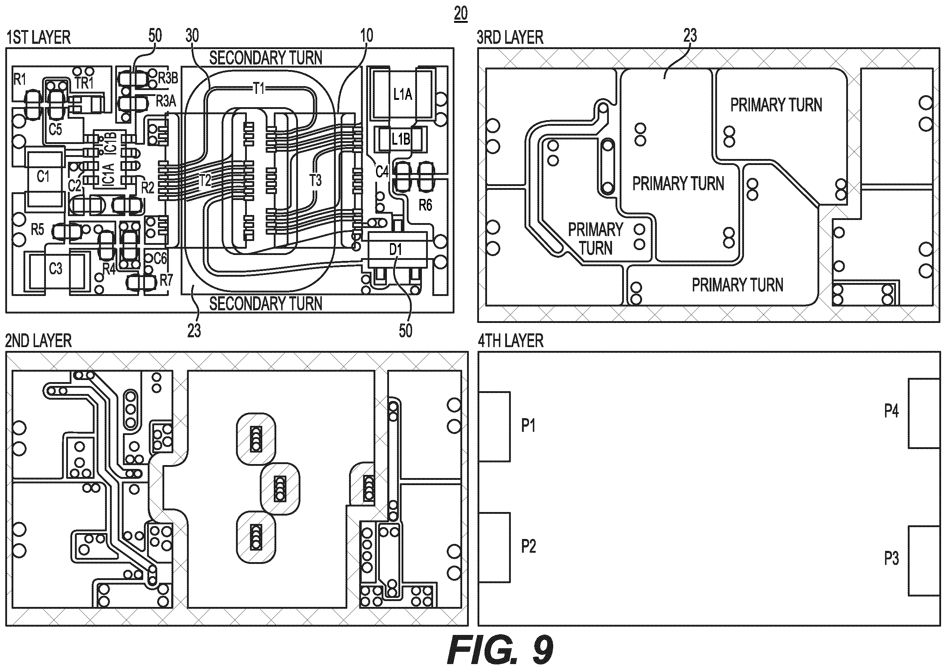

The substrate 20 can be any suitable substrate, including, for example, a printed circuit board (PCB). The substrate 20 can include a single layer or multiple layers and can include traces or conductive patterns 23 on an exterior surface (i.e., the top and the bottom surfaces) of the substrate 20 and/or in the substrate 20 (i.e., on an internal layer of the substrate 20). If the substrate 20 includes a single layer, then the traces or conductive patterns 23 of both the primary winding and the secondary winding can be located on the same layer, e.g., the top surface of the substrate 20. If the substrate 20 includes multiple layers, then the traces or conductive patterns 23 of the primary winding and the secondary winding can be located on the same layer or can be located on different layers. Fig. 9 shows four possible layers of the substrate 20. Although four layers are shown in Fig. 9, any number of layers can be used, including one layer.

As shown in Fig. 3 (in Fig. 3, the insulating material 40 is shown as transparent) and Fig. 4 (in Fig. 4, the insulating material 40 is not transparent), an insulating material 40 can be applied to the electronic module 200 to cover the substrate 20, the magnetic core 30, the two block coils 10, and any additional electronic component(s) 50. Any suitable insulating material 40 can be used, including, for example, a molding compound or an epoxy. The insulating material 40 can be applied in any suitable manner. The insulating material 40 can improve and help maintain isolation between the primary and the secondary circuit of the magnetic component 100. Insulating material 40 can also be applied to the magnetic component 100 of Fig. 1.

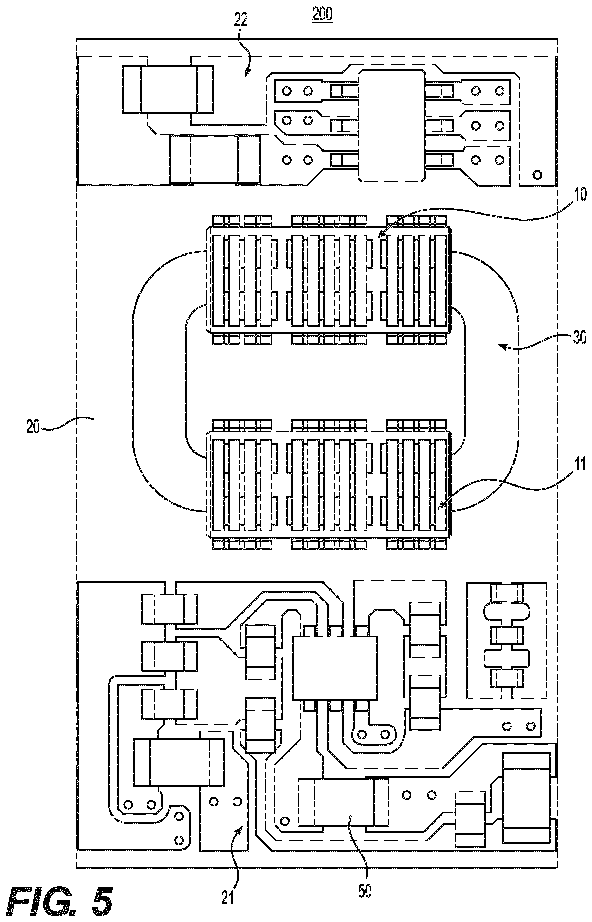

In Figs. 1 and 2, no additional electronic components 50 are shown on the substrate 20, but as shown for the electronic module 200 of Figs. 3 and 5, additional electronic component(s) 50 can be included on the substrate 20. The electronic component(s) 50 can be active components, such as transistors, integrated circuits (ICs), etc., or can be passive components, such as resistors, capacitors, inductors, etc. The electronic component(s) 50 can be connected to the same surface as the magnetic core 30 as shown in Figs. 3 and 5 and/or can be connected to the opposite surface as the magnetic core 30 (not shown). For example, locating capacitors on a surface of the substrate 20 opposite to the magnetic core 30 can contribute to (i) the "miniaturization" of electronic module 200 and (ii) prevent or greatly reduce short circuiting.

The electronic module 200 can be, for example, a power converter, isolator, or transformer, and the electronic components 50 can be the components of the power converter, isolator, or transformer. The electronic module 200 can be any suitable power converter, including, for example, a DC-DC converter or an AC-DC converter. For example, if the electronic module 200 is an isolated DC-DC converter, then, as shown in Figs. 3 and 5, electronic components 50 of a primary circuit 21 located on a first side of an isolation barrier can be located at one end of the substate, and electronic components 50 of a secondary circuit 22 located on a second side of the isolation barrier can be located at the opposite end of the substrate 20.

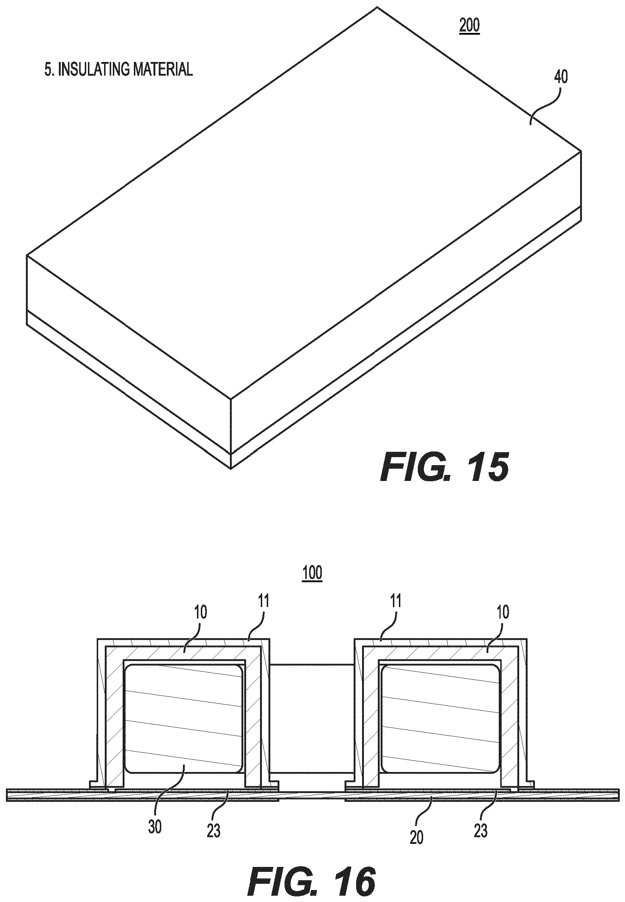

Fig. 16 shows a similar magnetic component 100 as Figs. 1 and 2, but the substrate 20 in Fig. 16 includes a single-layer substrate.

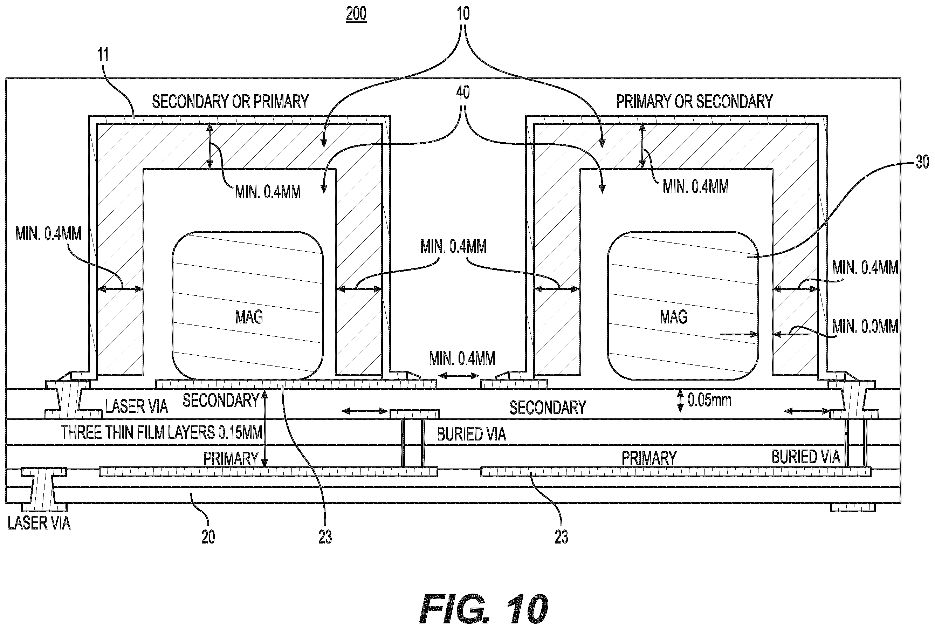

In Fig. 9, the 1^{st} layer of the substrate 20 shows the top surface of an electronic module 200 on which the magnetic core 30 can be located and to which the block coils 10 and the electronic components 50 can be attached. The 1^{st} layer can include traces or conductive patterns 23 that connect the electronic components 50. The traces 23 of the primary winding (i.e., primary traces or primary conductive patterns) and the traces 23 of the secondary winding (i.e., secondary traces or secondary conductive patterns) can be located on different layers of the substrate 20 as shown in Fig. 9 or can be located on the same layer of the substrate 20. For example, the primary traces 23 can be located on the 3^{rd} layer of the substrate 20, and the secondary traces 23 can be located on the 1^{st} layer. The primary traces 23 and the secondary traces 23 can be separated by one or more layers. In Fig. 9, the primary traces 23 and the secondary traces 23 are separated by the 2^{nd} layer of the substrate 20. In the cross-sectional view of Fig. 10, the primary traces 23 and the secondary traces 23 are separated by three thin film layers for a total separation of 0.15 mm. The hatched areas in Fig. 9 are keep-out areas, but other keep-out area arrangements are also possible. For example, the area on the 1^{st} layer between the feet 12 of the terminals 11 of the block coils 10 can also be a keep-out area, which as shown in Fig. 10 includes a keep-out area with a minimum width of 0.4 mm between the block coils 10. The outer layer of the substrate 20 can include input/output (I/O) terminals P1, P2, P3, P4 that can be used to connect the electronic module 200 to a host substrate (not shown). The I/O terminals P1, P2, P3, P4 can be surface mount technology (SMT) pads that can be soldered to corresponding pads on the host substrate in, for example, a reflow soldering process. I/O terminals P1, P2 can be connected to an input voltage, and I/O terminals P3, P4 can provide an output voltage. Although Fig. 9 shows four I/O terminals, any number and any arrangement of I/O terminals can be used. For example, the I/O terminals can be in-line I/O terminals that are arranged in a single row along one side of the substrate 20.

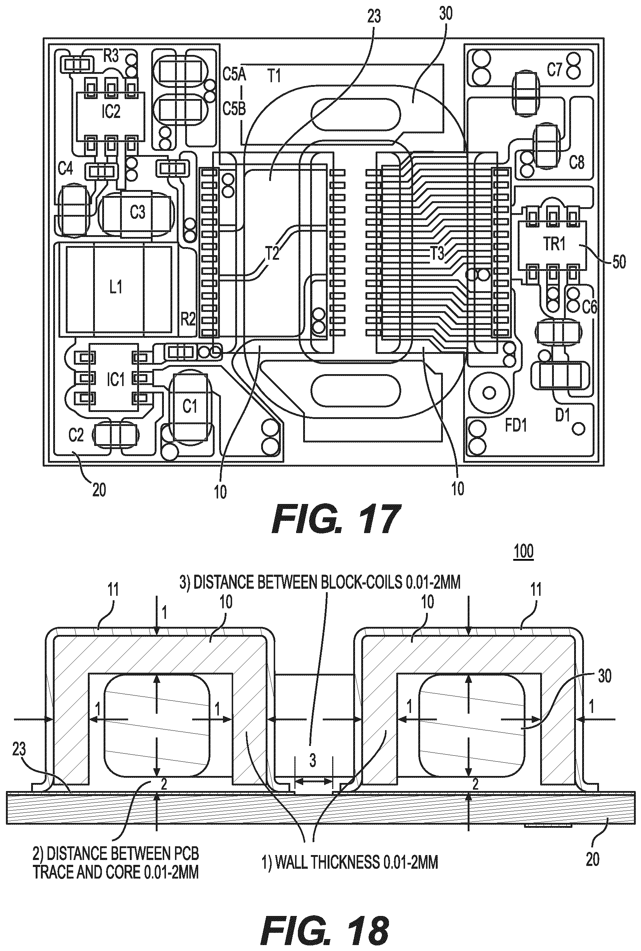

As shown in Fig. 9, one or more terminals 11 of each block coils 10 can be connected to a trace 23. For example, in one of the block coils 10, a single secondary trace 23 can connect a foot of one secondary terminal 11 to a foot of another secondary terminal 11 to define a single turn of the secondary winding, or in one of the block coils 10, a primary trace 23 can connect the feet 12 of three primary terminals 11 to the feet 12 of three other primary terminals 11 to define a single turn of the primary winding. That is, it is possible for a single turn of a winding to include one or more terminals 11 connected by a single trace 23. Fig. 17 shows a possible circuit arrangement of an electronic module 200 including either (a) a single-layer substrate 20 or (b) a multi-layer substrate 20 in which the electronic component(s) 50 and all of the traces 23 are on the top surface of the substrate 20. As in Fig. 9, one or more terminals 11 of each block coil 10 can be connected to a trace 23. The traces 23 on the substrate 20 can determine how many terminals 11 are included in a single turn and can determine how many turns are in either the primary or the secondary winding. Thus, the same block coil 10 can be used in different applications, which can save design costs because a different block coil 10 does not have to be made for each application.

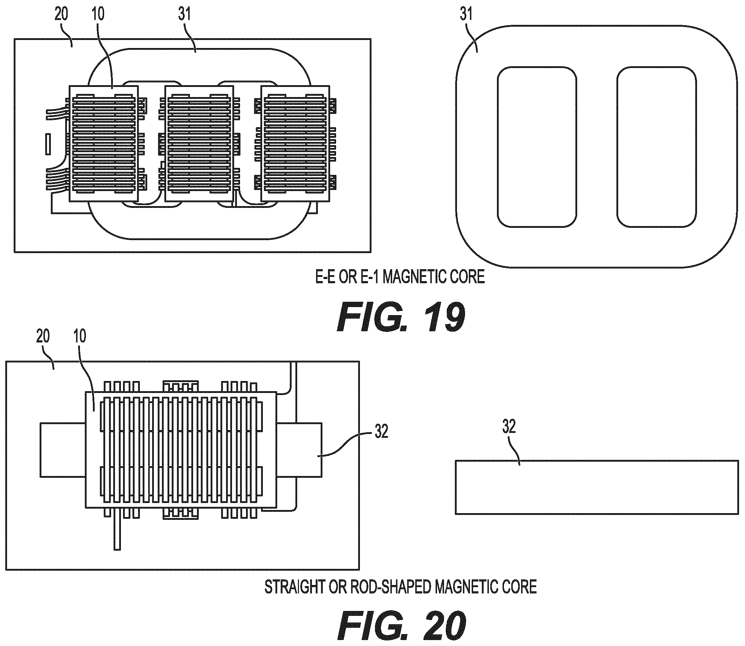

The magnetic core 30 can have any suitable shape including the ring shape shown in Figs. 1-3 and 5 or other suitable shapes such as E-I or E-E magnetic core 31 as shown in Fig. 19, a straight or rod-shaped magnetic core 32 as shown in Fig. 20, oval-shaped magnetic core (not shown), etc. The magnetic core 30, 31, 32 can include any suitable magnetic material, including, for example, ferrite. The magnetic core 30, 31, 32 can be coated or uncoated. Coating the magnetic core 30, 31, 32 can improve isolation. The coating can be any suitable material, including, for example, epoxy resin, polyimide, etc. The magnetic core 30, 31, 32 can be attached to the substrate 20 or the block coil(s) 10. If the magnetic core 30, 31, 32 is attached the block coil(s) 10, then the magnetic core 30, 31, 32 can be attached to an inner, upper surface of the block coil(s) 10.

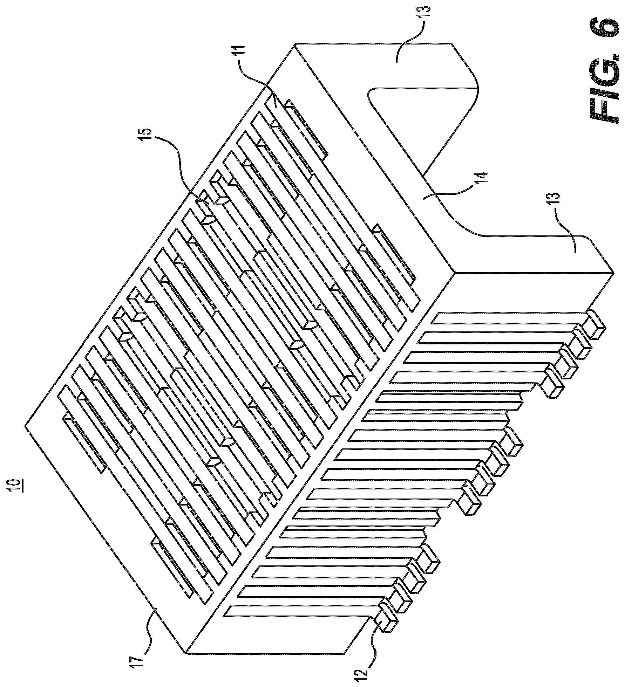

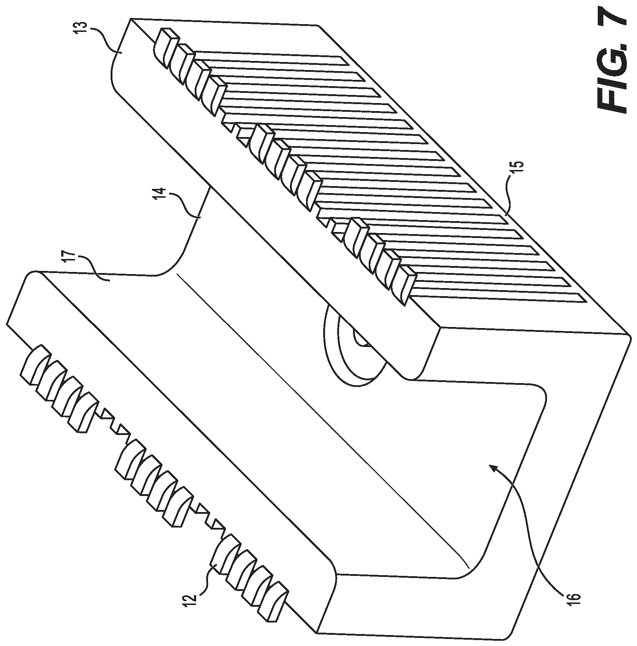

Figs. 6 and 7 show the block coil 10. The block coil 10 can include a resin body 17 and terminals 11. The resin body 17 can include two legs 13 connected by a bridge 14 to define a cavity or groove 16 that receives a portion of the magnetic core 30. The resin body 17 can have a U-shape as shown in Fig. 6 and 7 or can have any suitable shape such that the resin body 17 extends over or bridge the magnetic core 30. The resin body 17 can extend over three sides of a cross section of the magnetic core 30. The resin body 17 can include slots 15 in which the terminals 11 can be located or embedded in and can define a flat pick-up surface that a pick-and-place machine can use to precisely place the block coil 10 on a substrate 20 in one motion. That is, multiple turns of the winding(s) can be created with one motion. In addition, the block coil 10 provides a structure that protects the terminals 11 and prevents or greatly reduces any chance of short-circuiting. Because the resin body 17 allows different arrangements of terminals 11 to be used with the same resin body 17, the same resin body 17 can be used in different applications, which can save design costs because a different resin body 17 does not have to be made for each application. For example, if the resin body 17 is made by a molding process, then the same mold can be used for different applications, saving design costs. In Figs. 6 and 7, the slots 15 in the resin body 17 are visible, but in the finished product, the slots 15 may not be visible, for example, if a resin mold is used that fills the gaps in the slots 15.

The resin body 17 can be made of any suitable insulating material, including, for example, liquid crystal polymer (LCP) resin, and can be made in any suitable manner. The terminals 11 can be made of any suitable conductive material, including, for example, copper or copper alloy.

Fig. 6 shows twelve terminals 11 and four empty slots 15. Any number of terminals 11 can be used, including, for example, 14, 16, 18, 20, or more than 20 terminals. The terminals 11 can have a U-shape as shown in Fig. 6 and 7 or can have any suitable shape such that the terminals 11 extend over or bridge the magnetic core 30. The terminals 11 can extend over three sides of a cross section of the magnetic core 30. The terminals 11 can include feet 12 that can be surface mounted to the substrate 20. Alternatively, the terminals 11 can be connected to the substrate 20 in any suitable manner. The feet 12 of the terminals 11 can be attached to the substrate 20 such that the block coil 10, including the resin body 17, is located on or above the substrate 20. The terminals 11 can be located or embedded in slots 15 in the block coil 10. As shown in Fig. 6, not all of the slots 15 have to have a corresponding terminal 11. In Fig. 6, four slots 15 do not have a corresponding terminal 11, but any number of slots 15 could be empty. Fig. 6 shows sixteen slots 15, but any number of slots 15 could be used.

The terminals 11 in the block coil 10, along with traces 23 on or in the substrate 20, can be included in the windings of the magnetic component 100. If the windings include primary windings and secondary windings, then some terminals 11 can be included in the primary winding and be connected to primary traces 23, and some terminals 11 can be included in the secondary winding and be connected to secondary traces 23. Alternatively, all of the terminals 11 in the block coil 10 either can be included in the primary winding and be connected to primary traces 23 or can be included in the secondary winding and be connected to secondary traces 23. If all of the terminals 11 in one block coil 10 are included in the primary winding, then all of the terminals 11 in another block coil 10 can be included in the secondary winding, and vice versa. If all of the terminals 11 in one block coil 10 are included in the primary winding, then another block can include terminals 11 in both the primary winding and the secondary winding, and vice versa.

The terminals 11 in a block coil 10 can be included in groups. Which terminal group each terminal 11 belongs to is determined by the traces 23 on the substrate 20. For example, with one substrate 20, all of the terminals 11 might belong to a first terminal group, while with another substrate 20, the adjacent terminals 11 might be in two different terminal groups, either a first terminal group or a second terminal group. For example, Fig. 6 shows two terminal groups, i.e., first and second terminal groups. In Fig. 6, the first terminal group includes four first terminals 11 on each end of the block coil 10, and the second terminal group includes four second terminals 11 in the middle of the block coil 10 in between the first terminals 11 of the first terminal group. Other arrangements are also possible. For example, the first and second terminals 11 can alternate along the length of the block coil 10 such that each terminal 11 of one terminal group can be between two terminals 11 of the other terminal group. Alternatively, the terminal groups do not have to be split. That is, the terminals 11 of the first terminal group can be located on one end of the block coil 10 (e.g., seven first terminals 11 on one end), and the terminals 11 of the second terminal group can be located on the other end of the block coil 10 (e.g., seven second terminals 11 on the other end with two slots 15 in the middle without any terminals 11). The terminals 11 can also be arranged in a bifilar arrangement in which two windings are arranged next to each other. For example, adjacent terminals 11 can be connected to either a first primary winding or a second primary winding.

Each terminal 11 of the first or the second terminal group can be closer to an adjacent terminal 11 of the same group than a terminal 11 of the other group. That is, each first terminal 11 can be closer to another first terminal 11 than any second terminal 11, and each second terminal 11 can be closer to another second terminal 11 than any first terminal 11. Slots 15 between adjacent terminal groups can be empty (i.e., the number of terminals 11 can be reduced or thinned) to help improve isolation between the first and second terminal groups. More empty slots 15 between adjacent terminal groups can increase the isolation between the terminal groups. The adjacent terminal groups can be spaced away from each other. Instead of including empty slots 15, adjacent terminal groups can be spaced farther apart from each other than adjacent terminals 11 in a terminal group. For example, adjacent terminal groups can be spaced apart twice the distance that adjacent terminals 11 in a terminal group are spaced part, with no empty slots 15 between the adjacent terminal groups.

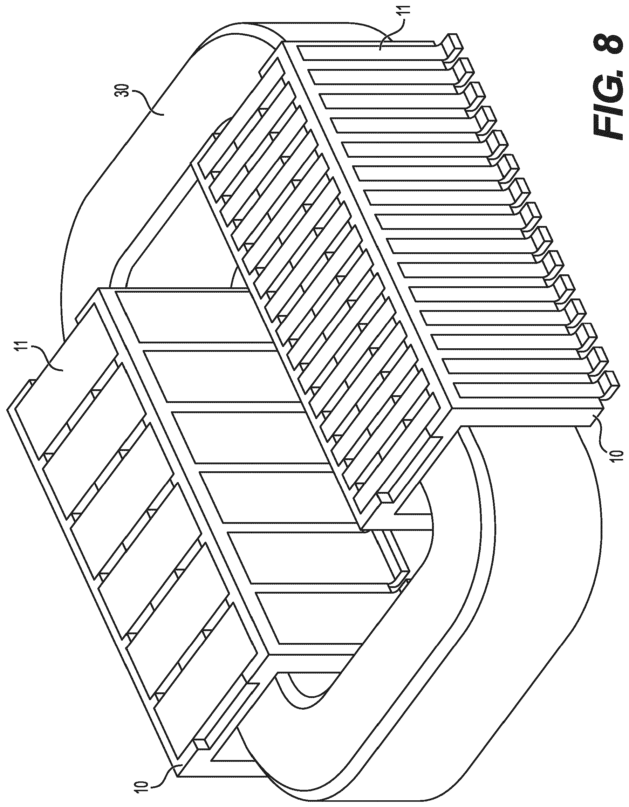

Fig. 8 shows two block coils 10 with terminals 11 with different widths. As shown in Fig. 8, the terminals 11 of each block coil 10 can have the same width. Alternatively, the terminals 11 with different widths can be included in the same block coil 10.

Fig. 10 shows the cross-section of two block coils 10 connected to a multi-layer substrate 20. Fig. 10 shows various minimum distances that ensure adequate isolation. For example, the walls of the resin body 17 should be at least 0.4 mm thick so that the terminals 11 are at least 0.4 mm from the cavity or groove 16 within the block coil 10. If the magnetic core 30 is coated, then 0.4 mm wall thickness can be reduced, for example, to 0.2 mm. The isolation distance will depend on the application. The minimum distance between the magnetic core 30 and the walls of the resin body 17 can be 0.0 mm so that there is no distance between the magnetic core 30 and the walls of the resin body 17. On the surface of substrate 20, the minimum distance between the traces or conductive patterns 23 of the primary and secondary circuits should be at least 0.4 mm.

As shown in Fig. 10, the substrate 20 can include laser vias that can be created by laser and that do not have to extend all the way through the substrate 20 and can include buried vias that extend between internal layers of the substrate 20 but that do not extend the external surfaces of the substrate 20. Each of the multiple layers of the substrate 20 can be 0.05 mm or approximately 0.05 mm within manufacturing and/or measurement tolerances. As shown in Fig. 10, the primary traces 23 and the secondary traces 23 can be separated by three internal layers such that the total distance between the primary traces 23 and the secondary traces 23 is at least 0.15 mm to ensure adequate isolation. Although a minimum distance of 0.4 mm between the primary and the secondary circuits is required on the surface of a substrate 20, the minimum distance between the primary and the secondary circuits inside of the substrate 20 depends on isolation requirement of each product. Other distances are also possible. For example, in Fig. 18, distance 1 is the thickness of the walls of the block coil 10 and can be about 0.01 mm to about 2.0 mm, within manufacturing and/or measurement tolerances; distance 2 is the distance between the trace 23 on the top layer of the substrate 20 and the magnetic core 30 and can be about 0.01 mm to about 2.0 mm, within manufacturing and/or measurement tolerances; and distance 3 is the smallest distance between the between the block coils 10 (which is the distance between the feet 12 of the terminals 11 in Fig. 18) and can be about 0.01 mm to about 2.0 mm, within manufacturing and/or measurement tolerances.

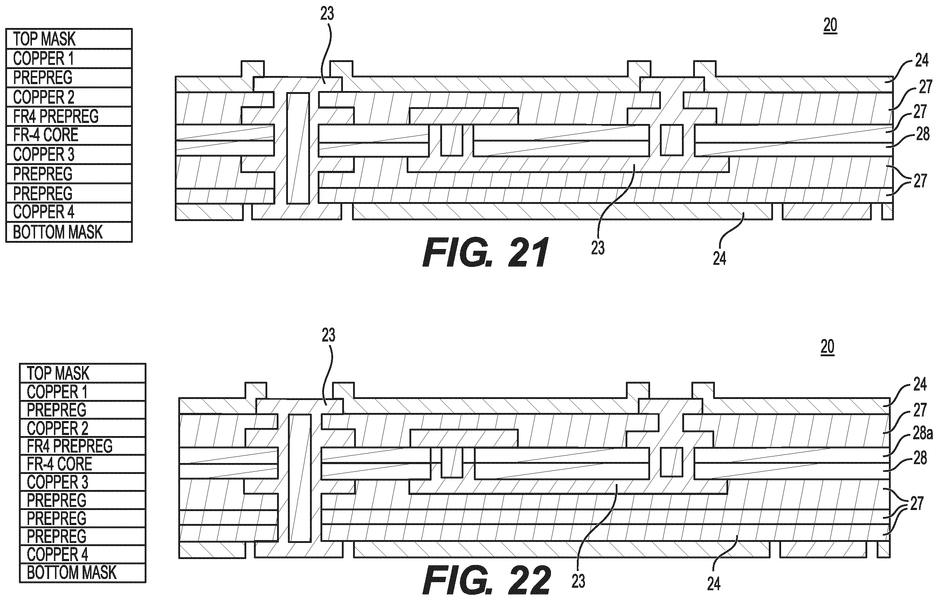

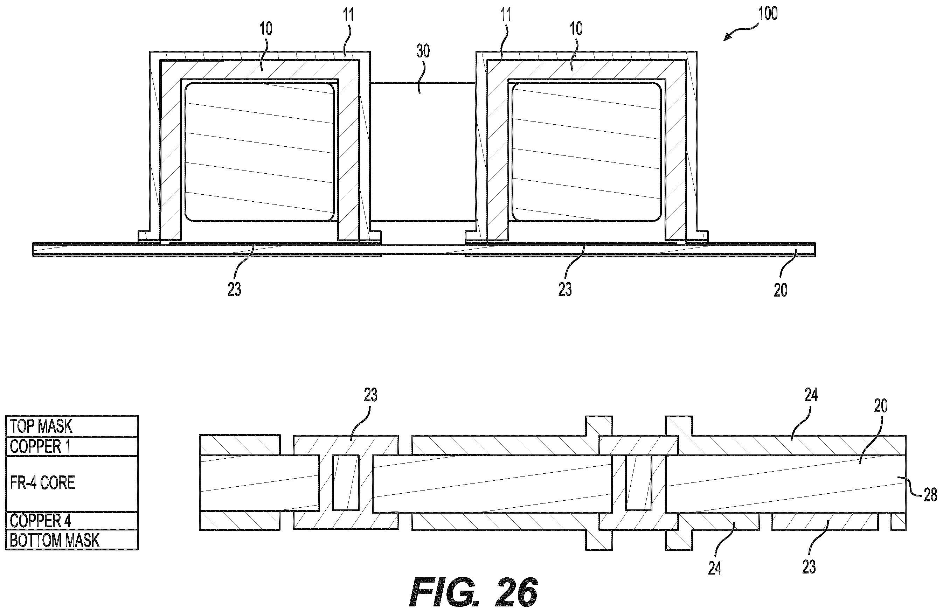

Figs. 21-26 show different possible substrates 20 that can be used in either a magnetic component 100 or in an electronic module 200. Figs. 21-25 show different possible multi-layer substrates 20, while Fig. 26 shows a single-layer substrate 20. As shown in Figs. 21-25, the substrate 20 can include multiple layers, including a top mask 24, one or more pre-preg layers 27, a core layer 28, one or more pre-preg layers 27, and a bottom mask 24. The core layer 28 can also include a core pre-preg layer 28a. The core layer 28 can include any suitable material, including, for example, FR-4. Traces 23 can be included on the top and bottom surfaces of the substrate 20 and can be included in interior layers of the substrate 20. The traces 23 on different layers can be connected by vias. The vias can include a hole in the substrate 20 that is plated with a conductive material, including, for example, a metal or metal alloy, and filled with any suitable material, including, for example, a resin. Alternatively, the vias can be filled with only conductive material. The vias can be made in any suitable manner, including, for example, mechanical drilling or laser drilling. Any suitable vias can be used, including, buried vias in which neither side of the vias is exposed on the top or bottom surface of the substrate 20, blind vias in which one side of the vias is exposed on the top or bottom surface of the substrate 20, and through-hole vias in which both sides of the vias are exposed on either the top or the bottom surface of the substrate 20. The traces 23 can include copper or other suitable conductive material. Similarly, as shown in Fig. 26, the substrate 20 can include a single layer, including a top mask 24, a core layer 28, and a bottom mask 24. The traces 23 in Fig. 26 can be located on the top or the bottom surfaces of the substrate 20.

Fig. 21 shows a multi-layer substrate 20 that includes a top mask 24, a pre-preg layer 27, a core pre-preg layer 28a, a core layer 28, two pre-preg layers 27, and a bottom mask 24. Traces 23 are located on the top and bottom surfaces of the substrate 20, the top surface of the core pre-preg layer 28a, and the bottom surface of the core layer 28.

Fig. 22 shows a multi-layer substrate 20 that includes a top mask 24, a pre-preg layer 27, a core pre-preg layer 28a, a core layer 28, three pre-preg layers 27, and a bottom mask 24. Traces 23 are located on the top and bottom surfaces of the substrate 20, the top surface of the core pre-preg layer 28a, and the bottom surface of the core layer 28.

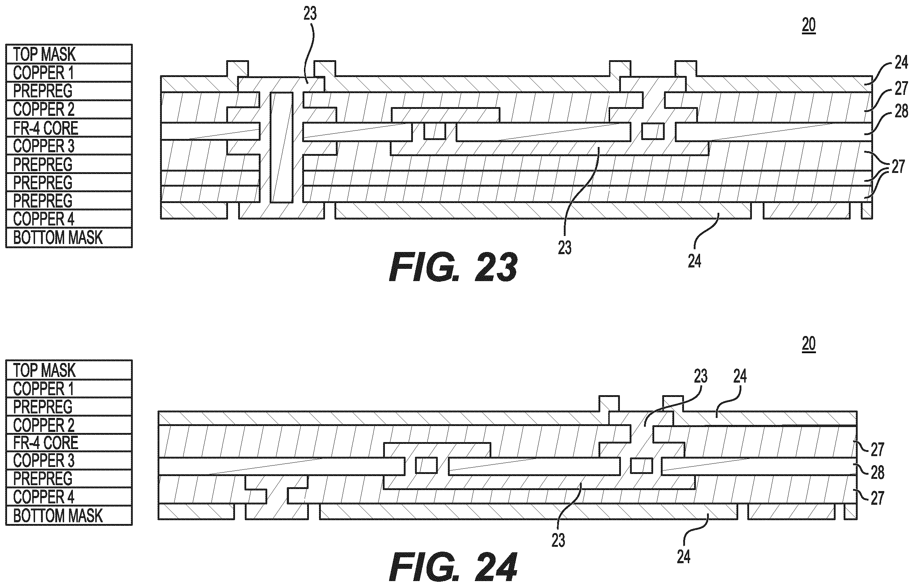

Fig. 23 shows a multi-layer substrate 20 that includes a top mask 24, a pre-preg layer 27, a core layer 28, three pre-preg layers 27, and a bottom mask 24. Traces 23 are located on the top and bottom surfaces of the substrate 20 and the top and bottom surfaces of the core layer 28.

Fig. 24 shows a multi-layer substrate 20 that includes a top mask 24, a pre-preg layer 27, a core layer 28, a pre-preg layer 27, and a bottom mask 24. Traces 23 are located on the top and bottom surfaces of the substrate 20 and the top and bottom surfaces of the core layer 28.

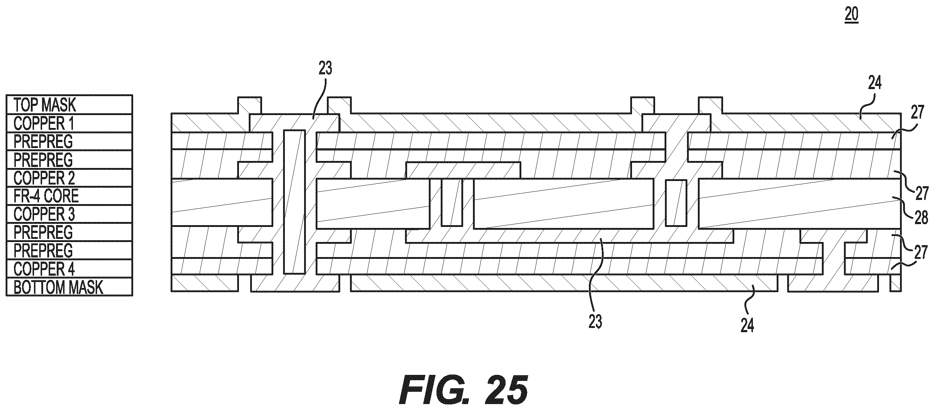

Fig. 25 shows a multi-layer substrate 20 that includes a top mask 24, two pre-preg layers 27, a core layer 28, two pre-preg layers 27, and a bottom mask 24. Traces 23 are located on the top and bottom surfaces of the substrate 20 and the top and bottom surfaces of the core layer 28.

The multi-layer substrate in Figs. 21-25 makes it easier to locate the primary and the secondary traces or conductive patterns 23 and to provide insulation between the primary and the secondary traces or conductive patterns 23. If multiple block coils 10 are used, then the multi-layer substrate in Figs. 21-25 can make it easier to provide isolation between the primary and the secondary traces or conductive patterns 23.

The bottom portion of Fig. 26 shows a single-layer substrate 20 that includes a top mask 24, a core layer 28, and a bottom mask 24. Traces 23 are located on the top and bottom surfaces of the substrate 20. The top portion of Fig. 26 shows a magnetic component 100 including two block coils 10 mounted to the single-layer substrate 20 and including a magnetic core 30. The traces 23 are on the top surface of the single-layer substrate 50. The single-layer substrate 20 allows for a smaller magnetic component 100 or electronic module 200. As an example, one of the block coils 10 can include primary terminals 11 and the other block coils 10 can include secondary terminals 11 so that primary traces 23 connected to the primary terminals 11 and the secondary traces 23 connected to the secondary terminals can be located on the same surface of the substrate 10.

As shown in Fig. 10, portions of the secondary traces 23 and the primary traces 23 can overlap vertically, which can improve coupling between the primary and the secondary windings. The larger the overlap between the primary and the secondary windings, the larger the coupling between the primary and the secondary windings. The resistance can be lowered if primary traces 23 or if the secondary traces 23 are located on adjacent layers. That is, the resistance can be lowered in the primary winding if primary traces 23 on different layers are only separated by a single layer, and the resistance can be lowered in the secondary winding if secondary traces 23 on different layers are only separated by a single layer.

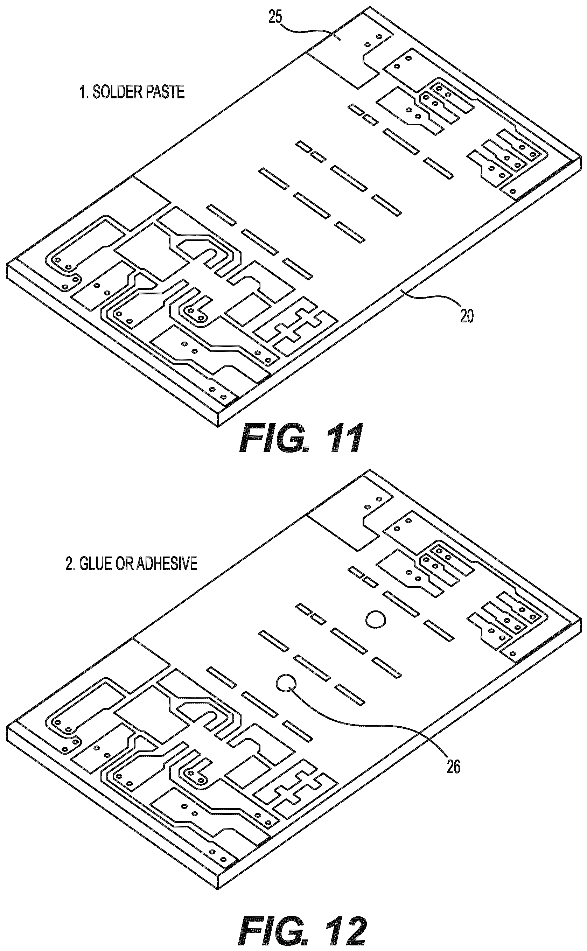

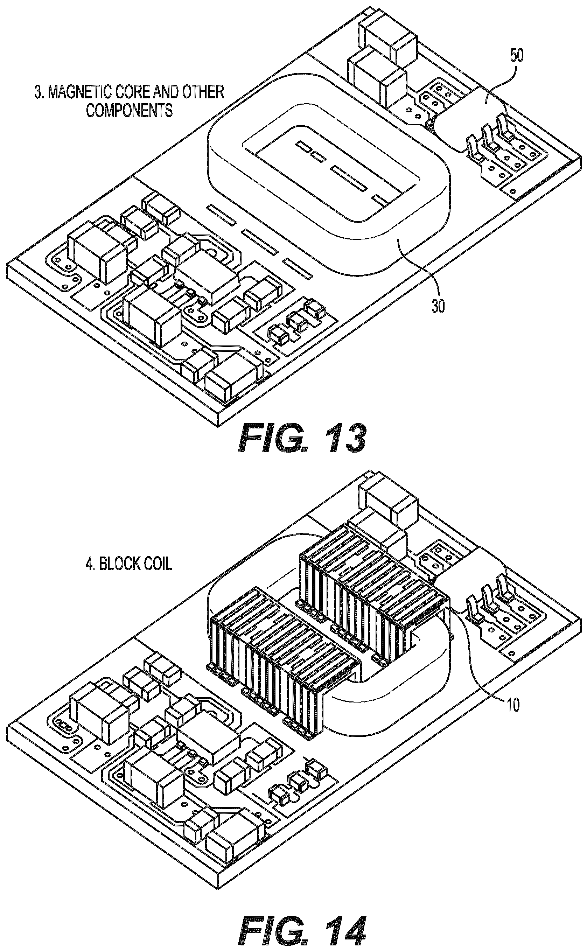

Figs. 11-15 show a method of making an electronic module 200 with block coils 10 mounted to a substrate 20. Fig. 11 shows providing a substrate 20 and them applying solder paste 25. The substrate 20 can be one of the substrates 20 discussed above and can be multilayer or single-layer substrate. Fig. 12 shows glue or adhesive 26 being dispensed on the substrate 20. The glue or adhesive 26 can be dispensed as part of a surface mount technology (SMT) process or separate from an SMT process. Fig. 13 shows the placement of the magnetic core 30 and the electronic component(s) 50. Fig. 14 shows the placement of two block coils 10 that extend over or bridge the magnetic core 30. Fig. 15 shows insulating material 40 covering the substrate 20, the electronic component(s) 50, the magnetic core 30, and the block coils 10. Fig. 15 shows that the insulating material 40 covers the entire substrate 20, but the insulating material 40 can cover only a portion of the substrate 40 and/or cover only one or some of the electronic component(s) 50, the magnetic core 30, and the block coils 10. Typically, a mother substrate can be used in which an array of electronic modules 200 are included in the mother substrate. The mother substrate is then diced or singulated to form individual electronic modules 200. Alternative, individual electronic module 200 can be manufactured without using a mother substrate.

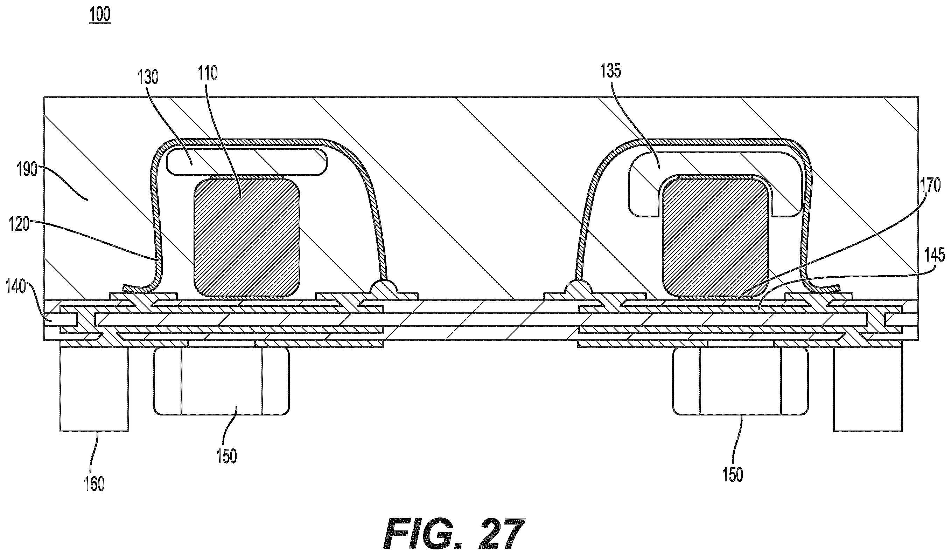

Instead of using the block coils 10, it is also possible to use wire bonds to define portions of the winding(s) that extend around the magnetic core. Figs. 27-31 show magnetic components 100 that use wire bonds 120 instead of block coils 10.

Fig. 27 shows a magnetic component 100 with a core 110, winding(s) that are defined by wire bonds 120 and traces 145, a spacer 130, and a substrate 140, such as a multilayer printed circuit board (PCB). It is noted that two examples of spacers are shown, including the spacer 130 and a spacer 135 in which the spacer 135 conforms to the top portion of the core 110 and partially covers the side walls of the core 110, as will be discussed below. An overmold material 190 can cover or encapsulate the core 110, the wire bonds 120, and the spacer 130. The magnetic component 100 can be a transformer with primary and secondary windings that extend around the core 110, as shown in Fig. 27. Although Fig. 27 shows a transformer with two windings, other magnetic components can also be used, including, for example, an inductor with a single winding or a transformer with three or more windings. Circuitry components and/or connectors can be located on the substrate 140. Fig. 27 shows the circuitry components and/or connectors on the bottom surface of the substrate 140, but alternatively or in addition to, the circuitry components and/or connectors can be on the top surface of the substrate 140. As shown in Fig. 27, the magnetic component 100 can include surface-mount (SM) or input/output (I/O) pins 160 that are located on the bottom surface of the substrate 140. The magnetic component 100 can include electrical components 150 mounted on the bottom surface of the substrate 140. The electrical components 150 can include passive components, such as, capacitors, resistors, etc. and can include active components, such as transistors, ICs, etc. The electrical components 150 can be used to implement an electrical converter.

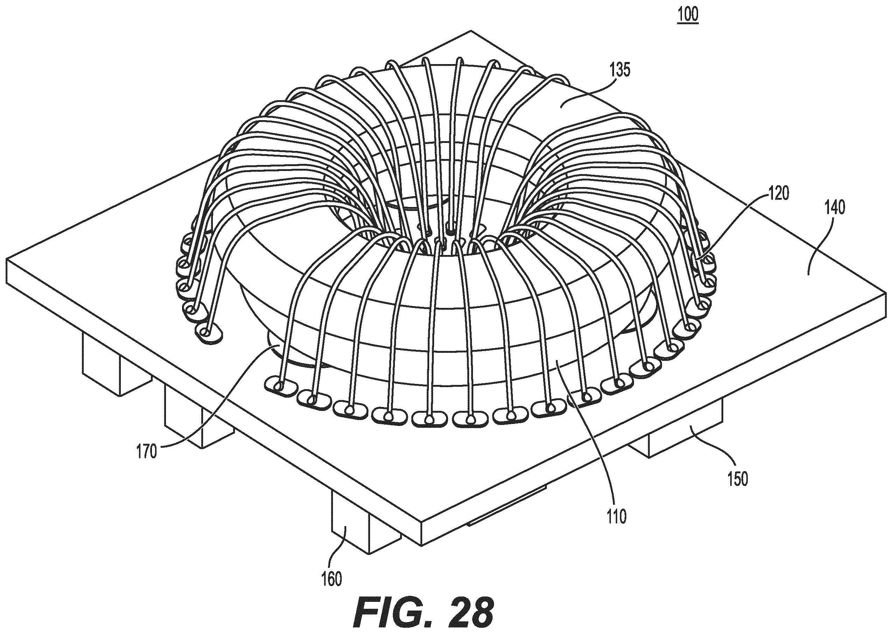

The core 110 can be an uninsulated core and can be fixed (i.e., adhered) to the multilayer substrate 140 with adhesive 170. The adhesive 170 can include spaced apart portions along the bottom of the core 110 as shown in Fig. 28 or can extend along the entire bottom of the core 110. The spacer 130 can be an insulated spacer and can be fixed (i.e., adhered) to a top of the core 140. The spacer 130 can be made by an injection molding process. The spacer 130 can be made with any suitable material that can be injection molded, including polyethylene terephthalate (PET) resin. The spacer 130 can help ensure that the wire bonds 120 do not contact the core 110, which would cause the magnetic component 100 to short circuit. Although the spacer is shown as a single unitary body in the figures, the spacer can include two or more bodies arranged around the core.

The windings are disposed around the core 110 and include wire bonds 120 that extend over the core 110 and traces 145 on or in the substrate 140 that extend under the core 110. The wire bonds 120 include two ends that are bonded to different portions of the substrate 140. The wire bonds 120 can be attached to the substrate 140 in a single row outside of the spacer 135 and in two rows in the interior of the spacer 135. Other arrangements are also possible, including two or more rows outside of the spacer 135 and one row or more than two rows in the interior of the spacer 135. The wire bonds 120 define a top half of a winding. The wire bonds 120 can include copper wires, gold wires, aluminum wires, or any other suitable conductive material. The wire bonds 120 can be attached to the substrate 140 by ball bonding, wedge bonding, compliant bonding, or any other suitable attachment method. The traces 145 can be located on inner or outer layers of the substrate 140 and define a bottom half of the winding. If the core 110 is uninsulated, then the traces 145 can be located on an inner layer or the bottom surface of the substrate 140. If the core 110 is insulated or if the spacer 130 completely surrounds the outer surface of the core 110, then the traces 145 can also be on the top surface of the substrate 140.

The left side of Fig. 27 shows an example of a spacer 130 between the top of the core 110 and the wire bonds 120 to prevent the wire from touching the core 110 and being short-circuited. As shown, the spacer 130 is wider than a width of the core 110 to create an overhang that maintains a predetermined distance between the wire bond 120 and the core 110. The right side of Fig. 27 shows an alternative configuration of the spacer 135 in which the spacer 135 conforms to the top portion of the core 110 and partially covers the side walls of the core 110. It should be understood that, typically, the spacer will have a single cross-sectional shape throughout the spacer and that the two different cross-sectional shapes shown in Fig. 27 are examples of possible cross-sectional shapes. Fig. 28 show a magnetic component 100 that uses the spacer 135 that conforms to the top portion of the core 110 and that partially covers the side walls of the core 110.

Fig. 27 also shows that the core 110, the spacer 130, and wire bonds 120 can be overmolded with an overmold material 190 to stabilize and protect the components of the magnetic-component module. Instead of overmolding, it is also possible to use a potting method or an encapsulation method to stabilize and protect the components of the magnetic-component module.

Fig. 28 shows an example of magnetic component 100 with the spacer 135 and without the overmold material 190. Fig. 28 shows the core 110, the wire bonds 120, the substrate 140, the components 150, the I/O pins 150, and the adhesive 170.

The wire bonds 120 can be terminated to the substrate 140 in a single row in the exterior of the core 110 and can be terminated to the substrate 140 in two rows in the interior of the core 110. Other arrangements are also possible. For example, the wire bonds 120 can be terminated to the substrate 140 in two or more rows in the exterior of the core 110 and/or can be terminated to the substrate 140 in one row or more than two rows in the interior of the core 110.

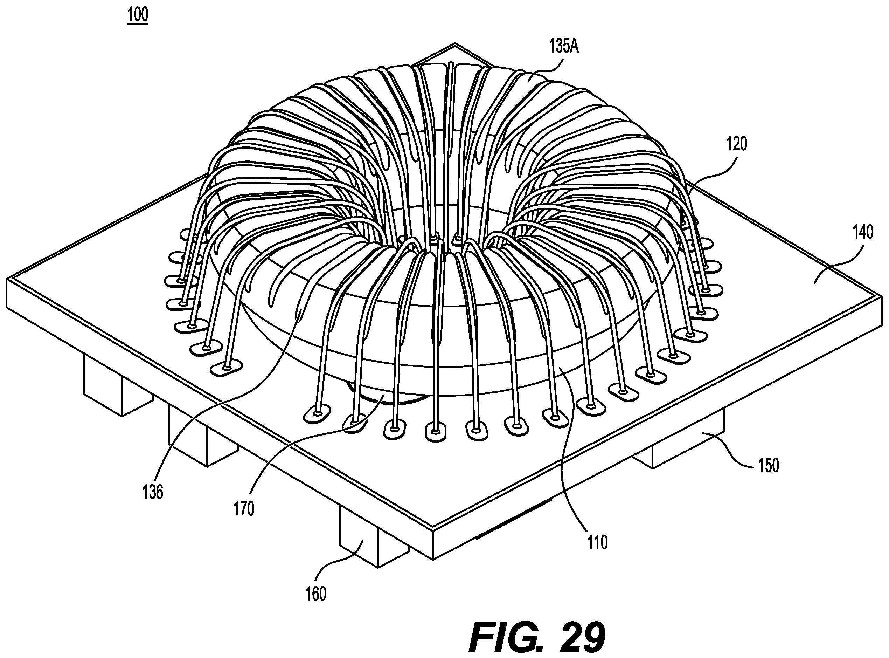

During the overmolding process, wire bonds 120 can be collapsed by pressure within a resin mold, causing the wire bonds 120 to collapse and short circuit with the core or an adjacent wire bond 120. To avoid this problem, as shown in Fig. 29, grooves 131, 136 are included in the spacer 130A, 135A so that the wire bonds 120 are located in the grooves 131, 136. A cross section of a shape of the grooves 131, 136 in the spacer 130A, 135A can be a U-shape, a V-shape, a rectangle, a semicircle, or any other suitable shape. Each wire bond 120 is located in a corresponding groove 131, 136 defined in the spacer 130A, 135A.

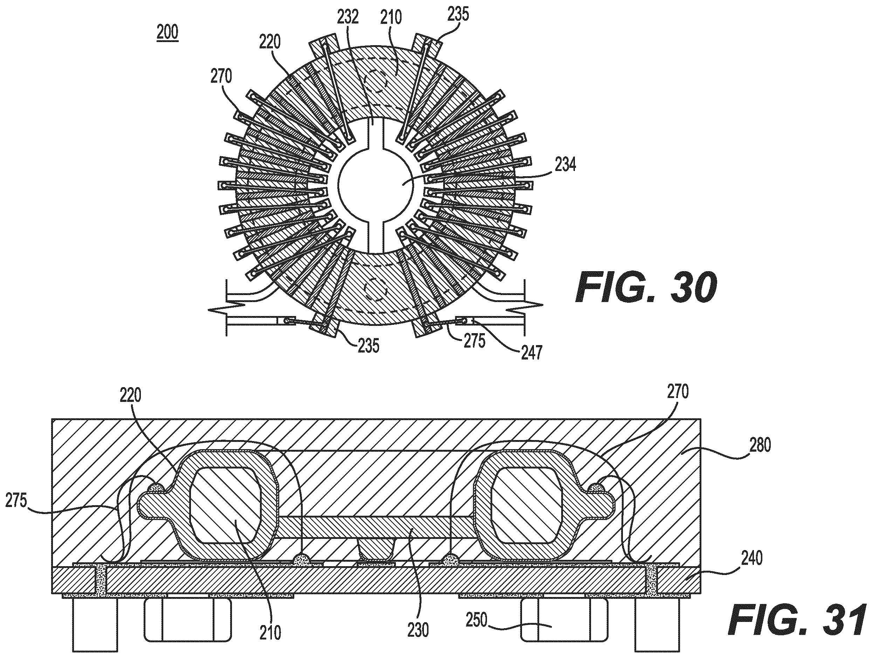

Figs. 30 and 31 show a magnetic component 100 with a core 210, winding(s) defined by traces 220 and wire bonds 270, a header 230, and a substrate 240, such as a printed circuit board (PCB). Fig. 31 is a sectional view of a magnetic component 100 with a header 230 that can be made by overmolding the core 210, and Fig. 30 shows a plan view of the header 230. In Fig. 30, the outline of a core 210 is represented by the dashed lines. The magnetic-component module 100 can be a transformer with primary and secondary windings that extend around the core 210. Although Figs. 30 and 31 show a transformer with two windings, other magnetic components can also be used, including, for example, an inductor with a single winding or a transformer with three or more windings. Circuitry components 250 and/or connectors can be located on the bottom surface of the substrate 240. The magnetic component 100 can include surface-mount (SM) pins 260 that can also be located on the bottom surface of the substrate 140. The circuitry components 250 can include passive components, such as, capacitors, resistors, etc. and can include active components, such as transistors, ICs, etc. The electrical components 250 can be used to implement an electrical converter. Although Fig. 31 shows a substrate 240 with no internal layers, it is also possible to use a multilayer substrate.

The header 230 isolates the core 210 from the windings and protects against short circuiting. Figs. 30 and 31 shows that the header 230 and wire bonds 270 can be overmolded with overmold material 280 to stabilize and protect the components of the magnetic component 100. Instead of overmolding, it is also possible to use a potting method or an encapsulation method to stabilize and protect the components of the magnetic component 100.

Windings extend around the core 210. The windings are defined by traces 220 located on the outer surface of the header 230 and by wire bonds 270 extending over the core 230 and traces 220 located on or in the substrate 240. The traces defining the windings 220 can be provided by plating, vapor deposition, or any other suitable process. Wire bonds 270 can be used to connect the traces on the header 230 to pads on the substrate 240. In Figs. 30 and 31, the tops and bottoms of the windings 220 are defined by the traces that extend around the core 210. But other arrangements are also possible. For example, the tops of the windings 220 can be defined by traces on the header 230, and the bottoms of the windings 220 can be defined by traces on or in the substrate 140. The traces in the substrate 240 can be connected to the traces on the header 230 by the wire bonds 270 and/or by including surface-mount pads (not shown) on the header 230.

The header 230 in Fig. 30 does not include any vias that extend through the header 230. But the header 230 can include vias in outer and inner ledges. The vias can be arranged in one or more rows in the outer and the inner ledges. The traces 220 on the header 230 can define a winding separate from the winding defined by the wire bonds 270 and the traces on or in the substrate 240. Alternatively, the traces 220 on the header 230, the wire bonds 270, and the traces on or in the substrate 240 can define a single winding. Furthermore, the direction of the windings defined by the traces 220 can be the same or different than the windings defined by the wire bonds 270.

The header 230 can include outer ledges 235. Fig. 30 shows four outer ledges 235, but any number of outer ledges can be used. A continuous outer ledge could be used but would require longer traces on the header 230 and more room to attach the wire bonds 270 to the substrate 240. Wire bonds 275 can be bonded to the outer ledges 235 to connect the traces 220 on header 230 to a pad or traces 247 on the substrate 240. The outer ledges 235 can also provide a location to connect the wire bonds 270 of the windings with the traces 220 of the windings. The interior of the header 230 can include a platform 234 attached to the header 230 by two arms 232. The two arms 232 can be arranged and the platform 234 can be designed small enough to allow the wire bonds 270 of the windings to be bonded in the interior of the header 230. The platform 234 can be used for pick-and-place placement. The platform 234 can include a conductive pad that can be used to surface mount the header 230 to the substrate 240. The conductive pad of the header 230 can be soldered to the substrate 240. Other possible arrangements to mount the header 230 to the substrate 240 can also be used.

The wire bonds 270 can be terminated in a single row or multiple rows. As shown in Fig. 30, the wire bonds 270 can be terminated to the substrate 240 in single rows in the exterior and the interior of the core 230. Other arrangements are also possible. For example, the wired bonds 270 can be terminated to the substrate 240 in two or more rows in the exterior of the core 210 and/or can be terminated to the substrate 240 in two or more rows in the interior of the core 210.

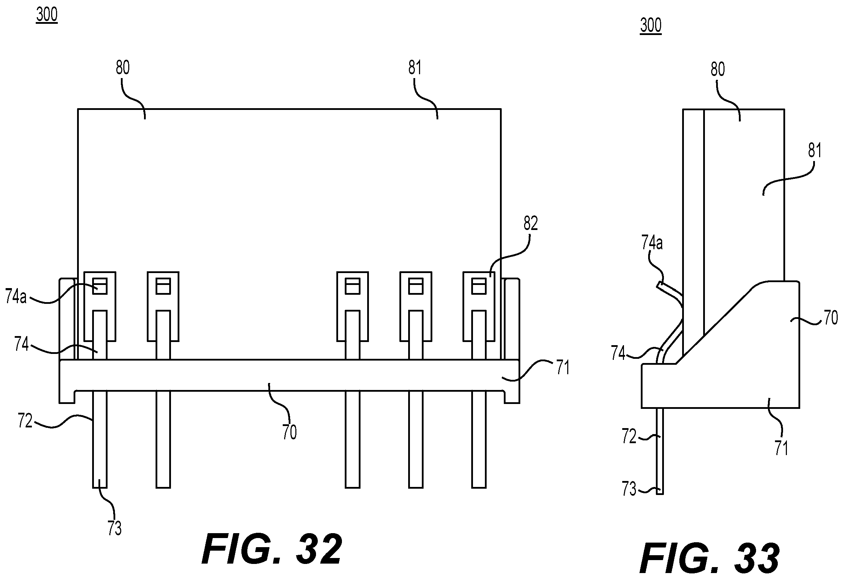

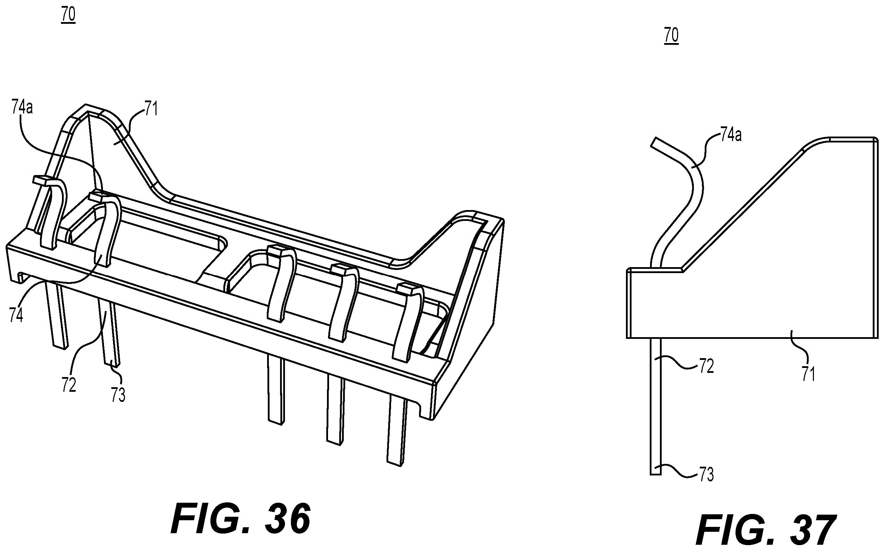

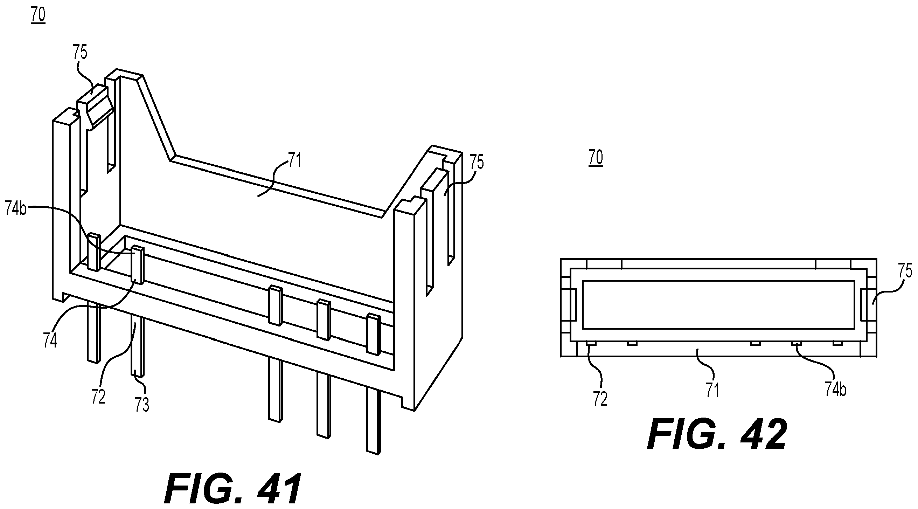

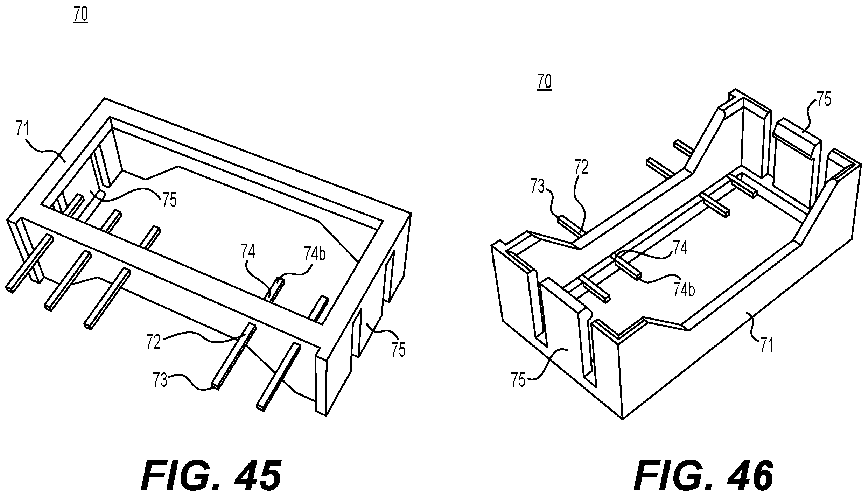

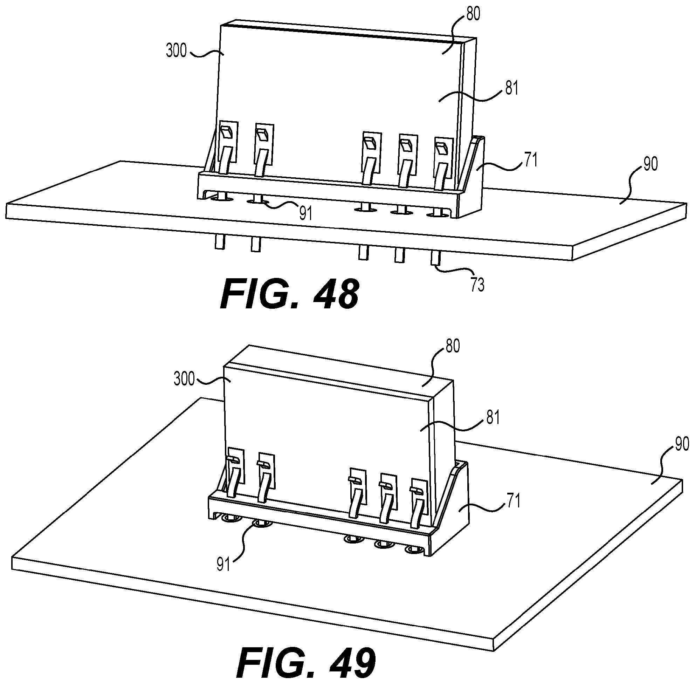

The magnetic components 100 and the electronic modules 200 discussed above can be manufactured with SMT to attach the magnetic component 100 and the electronic module 200 to a host substrate 90, as shown, for example, in Figs. 48 and 49. The magnetic component 100 and the electronic module 200 manufactured with SMT can be attached to an adapter that allows the magnetic component 100 and the electronic module 200 to be attached to a host substrate 90 using through holes 91, which can be, for example, plated through holes. Example adapters 70 are shown in Figs. 32-46. The adapters 70 can be attached to a module or component using SMT and that can be attached to a host substrate 90 using through holes 91. For example, the adapters 70 can include through-hole pins 72 in which one end of the through hole pins 72 can use SMT and in which the other end can use through holes.

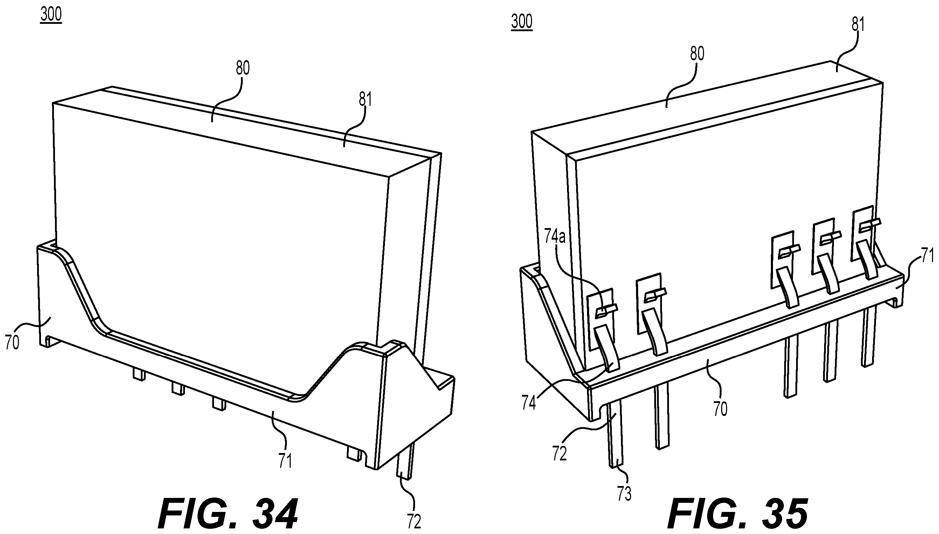

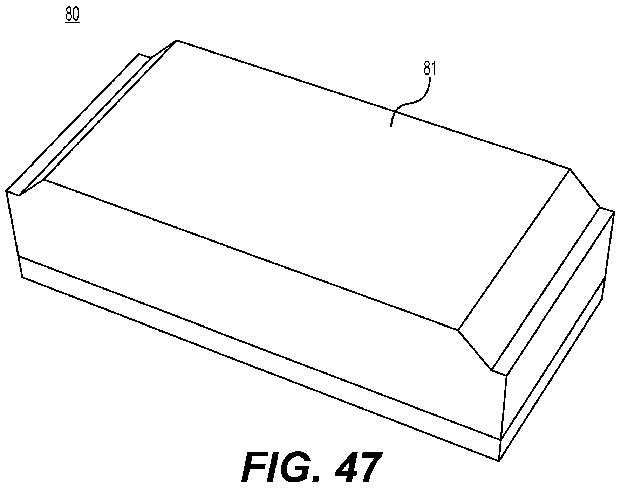

Figs. 32-46 show a through-hole-mountable element 300 with an adapter 70 that can be used to allow a magnetic component 80 to be attached to a host substrate (not shown) using through holes. The magnetic component 80 can be any suitable component, including, for example, either the magnetic component 100 or the electronic module 200. Fig. 47 shows an example of the magnetic component 80 that can be used with the adapter 70 of Figs. 32-46. The magnetic component 80 can include SMT pads 82 that can be soldered to corresponding SMT pads on a host substrate. The SMT pads 82 can define I/O terminals and correspond to I/O terminals P1, P2, P3, P4 in Fig. 9 and to I/O pins 160, 260 in Figs. 27-29 and 31. Fig. 9 above shows I/O terminals P1, P2, P3, P4 that can be used to surface mount the substrate 20 to a host substate. In Fig. 9, I/O terminals P1, P2 and I/O terminals P3, P4 are on opposite sides of the substrate 20. But the I/O terminals P1, P2, P3, P4 can also be arranged in a single line on one side of the substrate 20 as shown, for example, in Figs. 35, 38, and 39. Figs. 27-29 and 31 show I/O pins 160, 260 that can be used to surface mount the substrate 140, 240 to a host substrate. The I/O pins 160, 260 can also be arranged in a single line on one side of the substrate 140, 240. As shown in Figs. 35, 38, and 39, the number of I/O terminals is not limited to four and can be five. But any number of I/O terminals can be used.

The adapter 70 can include a housing 71 and through-hole pins 72. Figs. 32-46 show that the adapter 70 includes five inline through-hole pins 72 that are arranged in a single row, but any number and any arrangement of through-hole pins 72 can be used. For example, the adapter 70 can include fewer than five through-hole pins 72, e.g., one to four through-hole pins 72, or can include more than five through-hole pins 72, e.g., six or more through-hole pins 72. Each through-hole pin 72 can extend through the housing 71 and can include a through-hole-mounting end 73 that extends to the exterior of the housing 71 (i.e., outside of the portion of the housing 71 that houses the magnetic component 80) and can include an SMT end 74 that extends into the interior of the housing 71 (i.e., the portion of the housing 71 that houses the magnetic component 80). As shown in Figs. 32-46, the through-hole pins 72 can extend in a straight line or a substantially straight line, within manufacturing and/or measurement tolerances, to vertically mount the through-hole-mountable element 300 to the host substrate. Alternatively, the through-hole pins 72 can include one or more bends to horizontally mount the through-hole-mountable element 300 to the host substrate. The adaptor 70 can be made using any suitable plastic fabrication or resin molding process, including, for example, injection molding or 3D printing. The through-hole pin 72 can include any electrically conductive material, which typically is a metal. The base material of the through-hole pin 72 can be plated using another material, including, for example, nickel, gold, etc., to stop oxidation and/or to improve solderability. If the through-hole pins 72 is used to keep the magnetic component 80 or to hold the magnetic component 80 in the adaptor 70 without soldering or glue, then the through-hole pin 72 can include a material that provides a suitable spring tension.

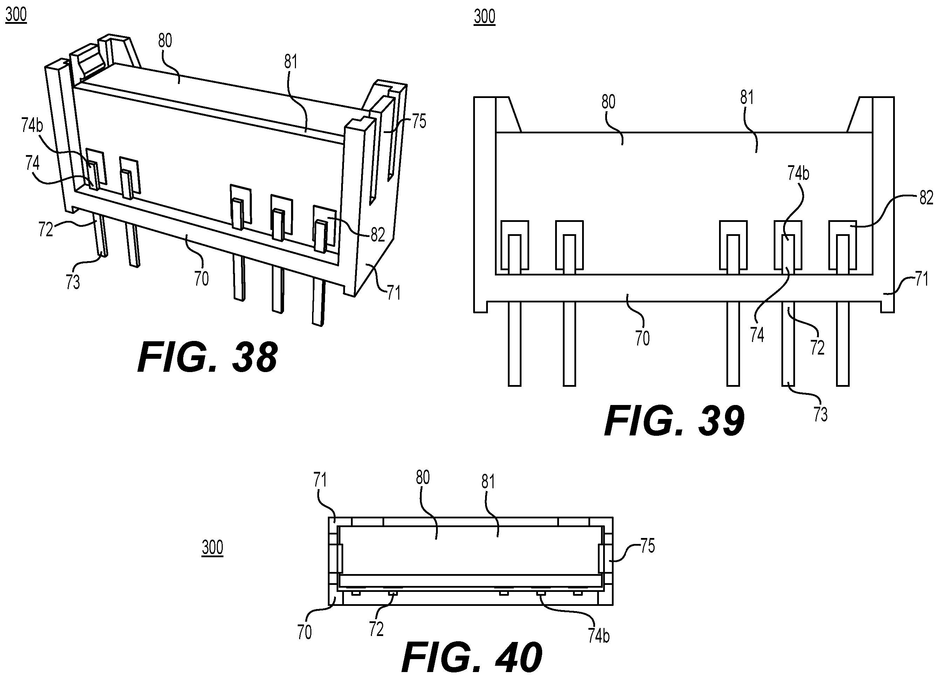

The SMT end 74 of the through-hole pins 72 can use any suitable SMT, including, for example, the spring arms 74a shown in Figs. 34-37 and including, for example, the solderable ends 74b shown in Figs. 38-46. As shown in Figs. 34-37, the spring arms 74a can provide a physical and electrical connection to the magnetic component 80 and can press on the SMT pads 82 of the magnetic component 80. As shown in Figs. 38-46, the solderable end 74b can provide a physical and electrical connection to the magnetic component 80 and can be soldered to the SMT pads 82 of the magnetic component 80. The through-hole pins 72 of Figs. 34-37 can include solderable ends 74b instead of spring arms 74a, and the through-hole pins 72 of Figs. 38-46 can include spring arms 74a instead of solderable ends 74b.

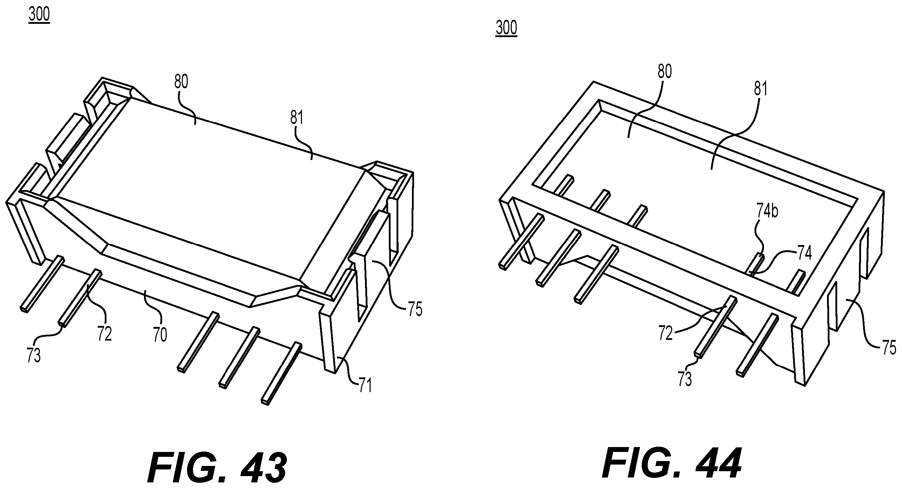

The magnetic component 80 can be secured into the housing 71 in any suitable manner. Figs. 34-37 show that the magnetic component 80 is secured by the spring arms 74a pressing on the magnetic component 80 with a retaining force. The retaining force ensures that the magnetic component is secured between the housing 71 and the spring arms 74a. This arrangement allows for a smaller housing 71 to be used. In Figs. 38-46, the magnetic component 80 can be secured in the housing 71 by soldering the solderable ends 74b of the through-hole pins 72 to the SMT pads 82 of the magnetic component 80. It is also possible to use lever arms 75 to secure the magnetic component 80 within the housing 71. The lever arms 75 can be cantilevered at one end and can include a ramp at the other end so that the magnetic component 80 can be snapped into the housing 71, securing the magnetic component 80 within the housing 71. In Figs. 38-42, the lever arms 75 are parallel or substantially parallel, within manufacturing and/or measurement tolerances, to the through-hole pins 72 so that magnetic component 80 can be vertically inserted into the housing 71. In Figs. 43-46, the lever arms 75 are perpendicular or substantially perpendicular, within manufacturing and/or measurement tolerances, to the through-hole pins 72 so that magnetic component 80 can be horizontally inserted into the housing 71. Although Figs. 38-46 show two opposing lever arms 75, any number and any arrangement of lever arms 75 can be used.

The magnetic component 80 of Fig. 47 can include a housing 81 and SMT pads 82 (on the bottom surface not shown in Fig. 47). Any suitable housing 81 can be used. The housing 81 can include the substrate 20 and the insulating material 40 as shown, for example, in Fig. 3 or can include the insulating material 40 as shown, for example, in Fig. 20.

It should be understood that the foregoing description is only illustrative of the present invention. Various alternatives and modifications can be devised by those skilled in the art without departing from the present invention. Accordingly, the present invention is intended to embrace all such alternatives, modifications, and variances that fall within the scope of the appended claims.

## Claims

1. An electronic module comprising:
a substrate including a primary conductive pattern and a secondary conductive pattern;
a magnetic core located on or above the substrate;
a primary winding including a first portion that extends around at least a portion of the magnetic core and that is connected to the primary conductive pattern; and
a secondary winding including a second portion that extends around at least a portion of the magnetic core and that is connected to the secondary conductive pattern;
an electronic component located on the substrate; and
an adapter that is connected to the electronic module and that includes at least one through-hole pin configured to through-hole mount the electronic module.

2. The electronic module according to Claim 1, further comprising a block coil that includes a first terminal that defines the first portion of the primary winding and a second terminal that defines the second portion of the secondary winding.

3. The electronic module according to Claim 1, further comprising a first wire bond that defines the first portion of the primary winding and a second wire bond that defines the second portion of the secondary winding

4. The electronic module according to one of Claim 1-3, wherein
the substrate includes first and second layers;
the primary conductive pattern is in the first layer;
the secondary conductive pattern is in the second layer; and
from a side view of the substrate, a portion of the primary conductive pattern and a portion of the secondary conductive pattern overlap vertically.

5. The electronic module according to one of Claims 1-4, further comprising an insulating material covering the substrate, the magnetic core, the primary winding, and the secondary winding.

6. The electronic module according to one of Claims 1-5, wherein the electronic component includes an integrated circuit (IC) and/or a capacitor.

7. A through-hole-mountable element comprising:
an adapter including a through-hole pin; and
a magnetic component including:
a substrate including a conductive pattern;
a magnetic core located on or above the substrate; and
a winding that includes a portion that extends around at least a portion of the magnetic core and that is connected to the conductive patter; wherein
the magnetic component is located within the adapter such that the magnetic component engages the through-hole pin such that the magnetic component is through-hole mountable.

8. The through-hole-mountable element of claim 7, wherein
the magnetic component includes a component housing that includes a surface mount technology (SMT) pad on an exterior surface of the component housing;
the adapter includes an adapter housing; and
the through-hole pin includes:
a through-hole-mounting end that extends to an exterior of the adapter housing; and
a surface mount technology (SMT) end that extends to an interior of the adapter to engage with the SMT pad on the component housing.

9. The through-hole-mountable element of claim 8, wherein the SMT end of the through-hole pin includes either a spring arm that presses on the magnetic component with a retaining force or a solderable end.

10. The through-hole-mountable element of one of claims 7-9, wherein the adapter housing includes a lever arm that presses on the magnetic component with a retaining force.

11. The through-hole-mountable element of claim 10, wherein
the through-hole pin extends in a first direction; and
the lever arm extends in a second direction parallel or substantially parallel to the first direction.

12. The through-hole-mountable element of one of claims 7-11, wherein the magnetic component is included in an electronic module that includes an electronic component on the substrate.

13. The through-hole-mountable element of one of Claims 7-12, further comprising a block coil that includes a terminal that defines the portion of the winding.

14. The through-hole-mountable element of one of Claims 7-12, further comprising a wire bond that defines the portion of the winding.

15. A system comprising:
a host substrate including a through hole; and
the through-hole pin of the through-hole-mountable element of one of claims 7-14 extends into the through hole of the host substrate to attach the through-hole-mountable element to the host substrate.
